# EUROPÄISCHE PATENTSCHRIFT

(11) **EP 1 203 412 B1**
(45) Veröffentlichungstag und Bekanntmachung des Hinweises auf die Patenterteilung: **25.12.2013**
(21) Anmeldenummer: 00954383.6
(22) Anmeldetag: 28.07.2000
(51) Int. Cl.: H01L 31/0232, G01J 1/42, G01J 1/58, G01J 1/04

(54) **PHOTODETEKTOR FÜR ULTRAVIOLETTE LICHTSTRAHLUNG**
PHOTODETECTOR FOR ULTRAVIOLET LIGHT RADIATION
PHOTODETECTEUR POUR RAYONNEMENT LUMINEUX ULTRAVIOLET

(30) Priorität: 30.07.1999 DE 19936000
(43) Veröffentlichungstag der Anmeldung: 08.05.2002
(73) Patentinhaber: OSRAM Opto Semiconductors GmbH, 93055 Regensburg (DE)
(72) Erfinder: KUHLMANN, Werner, D-81541 München (DE)
(74) Vertreter: Epping - Hermann - Fischer
(86) Internationale Anmeldenummer: PCT/DE2000/002492
(87) Internationale Veröffentlichungsnummer: WO 2001/009958

(56) Entgegenhaltungen:
- EP-A- 0 358 413
- WO-A-91/09326
- DE-A- 2 010 778
- DE-A- 4 301 177
- DE-A1- 1 589 771
- DE-B- 1 239 407
- DE-U1- 9 218 786
- FR-A- 2 769 979
- GB-A- 522 402
- GB-A- 2 200 987
- US-A- 3 891 849
- US-A- 4 096 387
- US-A- 4 348 664
- PATENT ABSTRACTS OF JAPAN vol. 005, no. 202 (P-095), 22. Dezember 1981 (1981-12-22) & JP 56 126726 A (MORIRIKA:KK), 5. Oktober 1981 (1981-10-05)
- GERTHSEN C. ET AL: 'Physik', SPRINGER VERLAG, BERLIN, ISBN 3-540-16155-4 * page 537; figure 11.2 *

## Beschreibung

Die Erfindung betrifft einen Photodetektor für ultraviolette Lichtstrahlung.

Die Realisierung hochempfindlicher UV-Photodetektoren auf der Basis von Silizium-Photodioden ist stets mit gewissen Schwierigkeiten verbunden. Dies liegt nicht so sehr an der Photoempfindlichkeit von Silizium im Wellenlängenbereich < 400 nm, da diese durch geeignete Konstruktion der Photodiode durchaus sehr gute Quantenwirkungsgrade von > 80 % erreichen kann, als vielmehr an der oft notwendigen Unterdrückung des längerwelligen Spektrums. So will man z.B. bei der Messung des UV-Anteils im Sonnenlicht oder bei der Flammenüberwachung in Öl- oder Gasbrennern den UV-Anteil vor einem hohen Hintergrund sichtbaren Lichts und von IR-Strahlung detektieren. Da die spektrale Empfindlichkeit des Siliziums im Bereich 200 nm bis ca. 900 nm stark mit der Wellenlänge ansteigt, kann diese Forderung nur durch aufwendige Filtermaßnahmen erfüllt werden.

Die europäische Patentschrift EP 0 296 371 B1 mit dem Titel "Photodetektor für Ultraviolett und Verfahren zur Herstellung" und die europäische Patentanmeldung EP 0 387 483 A1 mit dem Titel "Ultraviolettlicht-Photodiode" beschreiben jeweils einen UV-Photodetektor, der bei dem Produkt der Fa. SIEMENS mit der Bezeichnung "UV Sensor SFH 530" angewendet wird. Diesem Bauelement liegt die Forderung zugrunde, bei einer Wellenlänge von 310 ± 20 nm eine möglichst hohe Empfindlichkeit zu erzielen, diese jedoch bereits bei 400 nm und im gesamten weiteren Spektralbereich bis 1100 nm um den Faktor 10.000 abzusenken. Dies wird durch den folgenden Aufbau des Bauelements realisiert. Eine erste Wellenlängenselektion wird mit einem UV-Durchlaßfilter herbeigeführt, als welches das Glas-Filter UG 11 der Fa. Schott eingesetzt wird. Die noch vorhandenen Mängel in der Transmissionscharakteristik dieses Filters werden korrigiert mit einem Metall-Oxid-Interferenzfilter, welches direkt auf die zur Lichtdetektion verwendete Silizium-Photodiode aufgedampft wird. Die Photodiode selbst ist eine spezielle Konstruktion, die zwei übereinandergelegte pn-Übergänge aufweist. Der obere, extrem flache Übergang wird zur Detektion benutzt, während der untere Übergang intern kurzgeschlossen ist. Da die Eindringtiefe des Lichtes mit der Wellenlänge stark ansteigt, werden solchermaßen die längerwelligen Anteile wirkungsvoll unterdrückt. Das Bauelement enthält zusätzlich einen Operationsverstärker und ist in einem als TO-39 bekannten Standard-Metallgehäuse mit einer Quarzlinse im Lichteintrittsbereich eingebaut.

Dieses bekannte Konzept eines UV-Photodetektors hat den Nachteil, daß als Photodiode nur eine Silizium-Photodiode des oben beschriebenen speziellen Aufbaus verwendet werden kann. Zudem muß diese Silizium-Photodiode durch Aufdampfen des Metall-Oxid-Interferenzfilters eigens präpariert werden. Beides führt zu relativ hohen Herstellungskosten. Darüber hinaus erscheint die Empfindlichkeit dieser konventionellen UV-Photodetektoren angesichts der bei anderen Photodetektoren in anderen Wellenlängenbereichen erzielten Empfindlichkeitswerte verbesserungsbedürftig.

In der DE 43 01 177 A1 ist ein UV-Strahlungsdetektor beschrieben, bei dem UV-Strahlung mittels eines lumineszierenden Stoffes zunächst in sichtbares Licht konvertiert und anschließend auf die lichtempfindliche Fläche eines für sichtbares Licht empfindlichen Sperrschichtphotodetektors geführt wird. Es wird beschrieben, den fluoreszierenden Stoff in ein Gehäusefenster aus einem Kunststoff einzubringen, wobei als geeignete Materialien Polycarbonate enthaltende Polymere und Kunststoffe aus der Gruppe der Polystyrole, Polyester sowie Acrylsäureester genannt sind. Als optionale Ausführungsform ist angegeben, eine solarblinde Filterschicht zum Wegfiltern von Sonnenlicht hinunter bis etwa 290 nm zu verwenden. Diese Filterschicht kann auf eine den fluoreszierenden Stoff enthaltenden Schicht oder auf dem den fluoreszierenden Stoff enthaltenden Fenster aufgebracht werden.

Es ist eine Aufgabe der vorliegenden Erfindung, einen UV-Photodetektor mit niedrigeren Herstellungskosten und verbesserten Empfindlichkeitswerten anzugeben.

Diese Aufgabe wird durch einen Photodetektor mit den Merkmalen des Patentanspruches 1 oder des Patentanspruches 9 gelöst. Bevorzugte Weiterbildungen des Photodetektors sind Gegenstand der Patentansprüche 2 bis 8 und 10.

Demgemäß beschreibt die Erfindung einen Photodetektor für ultraviolette Lichtstrahlung, mit einer Halbleiterphotodiode, und einem im Strahlengang vor der Halbleiterphotodiode angeordneten UV-Durchlaßfilter, wobei zwischen dem UV-Durchlaßfilter und der Halbleiterphotodiode Konversionsmaterial derart angeordnet ist, daß zumindest ein Anteil der ultravioletten Lichtstrahlung in Lichtstrahlung mit längerer Wellenlänge umgewandelt wird.

In einer Ausführungsform enthält das Konversionsmaterial ein Szintillatormaterial, wie es üblicherweise bei der Herstellung von Leuchtstoffröhren verwendet wird. Ein bekanntes Szintillatormaterial wird von der Fa. OSRAM unter der Bezeichnung "Szintillator L 600" hergestellt und besteht aus Yttrium-Vanadat-Phosphat-Borat:EU, insbesondere in der formelmäßigen Zusammensetzung Y(V,PO₄)_{0,9} (BO₃)_{0,1}:Eu. Dieses Szintillatormaterial arbeitet mit einem Konversionswirkungsgrad der Umwandlung von ultravioletter Lichtstrahlung in Lichtstrahlung längerer Wellenlänge von 80 %. Das Szintillatormaterial weist ein Emissionsspektrum mit einem relativen Maximum bei 620 nm auf. Eine Silizium-Photodiode weist bei 600 nm eine Empfindlichkeit von 0,49 A/W gegenüber 0,24 A/W bei 300 nm auf. Daraus ergibt sich eine deutliche Empfindlichkeitszunahme des erfindungsgemäßen UV-Photodetektors.

Das Szintillatormaterial, welches in Pulverform vorliegt, wird in Silikon als Matrixmaterial eingemischt. Vorzugsweise wird das Szintillatormaterial in Form einer Schicht auf der lichtaustrittsseitigen Oberfläche des UV-Durchlaßfilters oder auf der Oberfläche eines gegebenenfalls zusätzlich vorhandenen Trägersubstrats aufgebracht.

Falls die Dämpfung der Anordnung im Bereich 400 bis 450 nm zu gering ist, kann dieser Anteil durch ein weiteres Filter unterdrückt werden. Hierfür eignet sich insbesondere ein Kantenfilter, wie z.B. von der Fa. Schott mit der Bezeichnung GG 475. Gewünschtenfalls kann dann die Schicht des Szintillatormaterial auch auf der lichteintrittsseitigen Oberfläche dieses Kantenfilters aufgebracht werden.

Der Aufbau der Anordnung kann, falls gewünscht, in gleicher Weise wie bei dem bekannten Detektor SFH 530 erfolgen, bei dem in einem TO-Gehäuse der UV-Durchlaßfilter getrennt von der Silizium-Photodiode gehaltert wird. Es ist aber ebenso denkbar, das UV-Durchlaßfilter mit der aufgebrachten Schicht des Konversionsmaterials direkt auf die Oberfläche der Halbleiterphotodiode zu montieren, insbesondere zu kleben. Diese Einheit kann dann mit einem geeigneten Kunststoff umspritzt oder umgossen werden, womit ein fertiges Detektorbauelement hergestellt ist.

Im folgenden wird ein einziges Ausführungsbeispiel der vorliegenden Erfindung anhand der Zeichnungen näher erläutert. Es zeigen:
- Fig. 1: eine Prinzipdarstellung der Bauelemente eines konventionellen UV-Photodetektors;
- Fig. 2: eine Prinzipdarstellung der Bauelemente eines erfindungsgemäßen UV-Photodetektors.

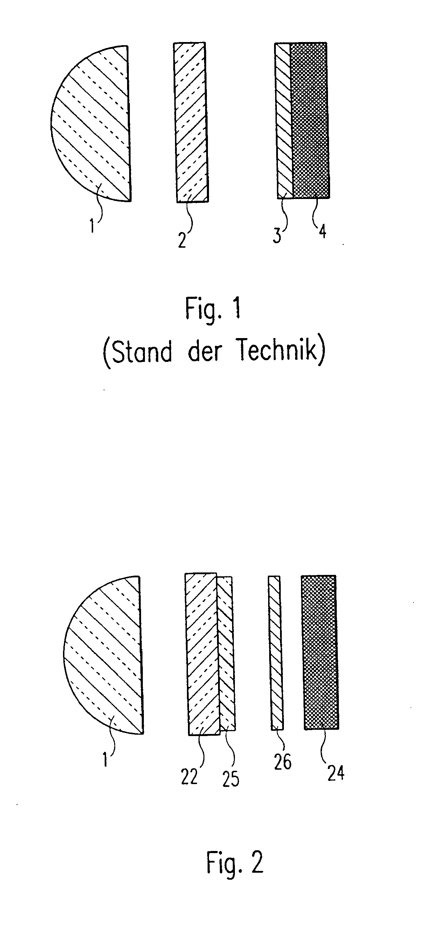

Der in Fig. 1 dargestellte konventionelle UV-Photodetektor weist auf der Lichteintrittsseite eine Quarzlinse 1 auf, durch die die einfallende Strahlung gebündelt werden soll. Mit einem UV-Durchlaßfilter 2 wird dann eine erste Wellenlängenselektion vorgenommen. Zu diesem Zweck wird ein Glas-Filter UG 11 der Fa. Schott verwendet. Eine zweite Wellenlängenselektion wird dann mit einem Metall-Oxid-Interferenzfilter 3 vorgenommen, welches direkt auf die Silizium-Photodiode 4 aufgedampft ist. Die Silizium-Photodiode 4 ist, wie bereits eingangs beschrieben, in besonderer Weise für den speziellen Anwendungszweck präpariert worden.

Bei dem erfindungsgemäßen Ausführungsbeispiel gemäß Fig. 2 wird zunächst wie beim Stand der Technik eine erste Wellenlängenselektion mit einem UV-Durchlaßfilter 22, wie den Filtertypen Schott UG 11 oder DUG 11 X (verbesserte Version), vorgenommen. Dann wird jedoch durch Wellenlängenkonversion mittels eines geeigneten Konversionsmaterials die UV-Strahlung absorbiert und in Lichtstrahlung längerer Wellenlänge, z.B. im grünen oder roten Spektralbereich, umgewandelt. Als Konversionsmaterial kann ein Szintillatormaterial verwendet werden, wie es üblicherweise in Leuchtstoffröhren verwendet wird, um dort die von dem Leuchtstoffgas emittierte UV-Strahlung in Strahlung im sichtbaren Wellenlängenbereich umzuwandeln. Ein Beispiel hierfür ist der Szintillator L 600 der Fa. OSRAM, der bei Anregung durch UV-Lichtstrahlung ein Emissionsspektrum aufweist, welches bei ca. 620 nm, also im roten Spektralbereich, eine relativ schmale Emissionsbande aufweist. Der Szintillator, der als feines Pulver vorliegt, wird in das Trägermaterial Silikon eingemischt und kann als eine Szintillatorschicht 25 direkt auf das W-Durchlaßfilter 22 aufgebracht werden. Als Trägermaterial für den Szintillator kann gegebenenfalls auch ein Epoxidharz verwendet werden, wobei jedoch hierbei gegenüber Silikon mit einer geringeren Transparenz als auch Beständigkeit gegenüber UV-Strahlung gerechnet werden muß.

Als Halbleiterphotodiode 24 kann eine Standard-Photodiode verwendet werden, die wesentlich kostengünstiger herzustellen ist und technologisch weniger Probleme bereitet als die im Stand der Technik verwendete präparierte Halbleiterphotodiode.

Anstelle der Verwendung eines Metall-Interferenzfilters wie beim Stand der Technik kann in dem erfindungsgemäßen Ausführungsbeispiel der Fig. 2 zur Dämpfung im Bereich 400 bis 450 nm nun auch ein gewöhnliches Kantenfilter 26, z.B. Schott GG 475, verwendet werden. Dieses Filter verbessert den Empfindlichkeitsabfall der Anordnung zwischen 350 und 400 nm. In einer alternativen Ausführungsvariante wird das Konversionsmaterial nicht auf die lichtaustrittsseitige Oberfläche des UV-Filters 22, sondern auf die lichteintrittsseitige Oberfläche des gegebenenfalls vorhandenen Kantenfilters 26 aufgebracht. Es kann auch vorgesehen sein, daß das Konversionsmaterial in Form einer Schicht auf einen eigens zusätzlich vorhandenen Träger aufgebracht wird, der sich zwischen dem UV-Durchlaßfilter 22 und der Halbleiterphotodiode 24 oder zwischen dem UV-Durchlaßfilter 22 und dem gegebenenfalls vorhandenen Kantenfilter 26 befindet.

Die beschriebenen Elemente können zusammen mit einer Quarzlinse 1 und einem Operationsverstärker in ein Standard-TO-Gehäuse eingebaut werden.

## Patentansprüche

1. Photodetektor für ultraviolette Lichtstrahlung, mit
- einer Halbleiterphotodiode (24),
- einem im Strahlengang vor der Halbleiterphotodiode (24) angeordneten UV-Durchlaßfilter und
- einem zwischen dem UV-Durchlaßfilter (22) und der Halbleiterphotodiode (24) angeordneten Konversionselement, das zumindest einen Anteil der durch den UV-Durchlaßfilter (22) hindurchtretenden ultravioletten Lichtstrahlung in Lichtstrahlung mit längerer Wellenlänge umwandelt,
**dadurch gekennzeichnet, dass**
bei dem Konversionselement ein Konversionsmaterial, das ein Szintillatormaterial, das als Pulver vorliegt, enthält, in Silikon eingemischt ist.

2. Photodetektor nach Anspruch 1,
bei dem das Szintillatormaterial Yttrium-Vanadat-Phosphat-Borat:Eu, insbesondere in der formelmäßigen Zusammensetzung Y(V, PO₄)_{0,9} (BO₃)_{0,1}:Eu ist.

3. Photodetektor nach einem der vorhergehenden Ansprüche,
bei dem zwischen dem UV-Filter (22) und der Halbleiterphotodiode (24) ein Kantenfilter (26) zur Unterdrückung des UV- und Blauanteils der aus dem Konversionselement tretenden Lichtstrahlung angeordnet ist.

4. Photodetektor nach einem der vorhergehenden Ansprüche,
bei dem das Konversionselement in Form einer Silikonschicht (25), in die das Konversionsmaterial eingemischt ist, auf der lichtaustrittsseitigen Oberfläche des UV-Durchlaßfilters (22), der lichteintrittsseitigen Oberfläche des gegebenenfalls vorhandenen Kantenfilters (26) oder auf einem anderen Trägersubstrat angeordnet ist.

5. Photodetektor nach einem der vorhergehenden Ansprüche, bei dem die Halbleiterphotodiode (24) eine Silizium-Photodiode
ist.

6. Photodetektor nach einem der vorhergehenden Ansprüche, bei dem das UV-Filter (22) und das gegebenenfalls vorhandene Kantenfilter (26) direkt auf die Oberfläche der Halbleiterphotodiode (24) montiert, insbesondere geklebt ist.

7. Photodetektor nach einem der vorhergehenden Ansprüche, bei dem in Strahlungsrichtung vor dem UV-Filter (22) eine Linse (1), insbesondere aus Quarzmaterial angeordnet ist.

8. Photodetektor nach einem der vorhergehenden Patentansprüche,
bei dem das Szintilatormaterial für eine Verwendung in einer Leuchtstoffröhre geeignet ist.

## Claims

1. Photodetector for ultraviolet light radiation, with
- a semiconductor photodiode (24),
- a UV transmission filter arranged in front of the semiconductor photodiode (24) in the path of rays and
- a conversion element arranged between the UV transmission filter (22) and the semiconductor photodiode (24), which element converts at least a proportion of the ultraviolet light radiation passing through the UV transmission filter (22) into light radiation with a longer wavelength,
**characterized in that**
in the case of the conversion element, a conversion material, which contains a scintillator material present in the form of powder, is mixed into silicone.

2. Photodetector according to Claim 1, in which the scintillator material is yttrium-vanadate-phosphate-borate:Eu, in particular in the formulaic composition Y(V,PO₄)_{0.9} (BO₃)_{0.1}:Eu.

3. Photodetector according to one of the preceding claims, in which an edge filter (26) is arranged between the UV filter (22) and the semiconductor photodiode (24) to suppress the UV and blue components of the light radiation emerging from the conversion element.

4. Photodetector according to one of the preceding claims, in which the conversion element in the form of a silicone layer (25) into which the conversion material has been mixed is arranged on the surface on the light-exiting side of the UV transmission filter (22), the surface on the light-entering side of the edge filter (26), if present, or on some other carrier substrate.

5. Photodetector according to one of the preceding claims, in which the semiconductor photodiode (24) is a silicon photodiode.

6. Photodetector according to one of the preceding claims, in which the UV filter (22) and the edge filter (26), if present, are mounted, in particular adhesively bonded, directly on the surface of the semiconductor photodiode (24).

7. Photodetector according to one of the preceding claims, in which a lens (1), in particular of quartz material, is arranged in front of the UV filter (22) in the direction of radiation.

8. Photodetector according to one of the preceding patent claims, in which the scintillator material is suitable for use in a fluorescent tube.

## Revendications

1. Photodétecteur de rayonnement lumineux ultraviolet, présentant :
une photodiode semi-conductrice (24),
un filtre laissant passer les UV, disposé en amont de la photodiode semi-conductrice (24) dans le parcours du rayonnement et
un élément de conversion disposé entre le filtre (22) laissant passer les UV et la photodiode semi-conductrice (24) et qui convertit au moins une partie du rayonnement lumineux ultraviolet qui traverse le filtre (22) laissant passer les UV en un rayonnement lumineux de longueur d'onde plus longue,
**caractérisé en ce que**
l'élément de conversion contient un matériau de conversion dans lequel un matériau scintillant présentant la forme d'une poudre est mélangé dans du silicone.

2. Photodétecteur selon la revendication 1, dans lequel le matériau scintillant est un yttrium-vanadate-photsphate-borate:Eu, dont la formule de composition est en particulier Y(V,PO₄)_{0,9}(BO₃)_{0,1}:Eu.

3. Photodétecteur selon l'une des revendications précédentes, dans lequel un filtre de bord (26) qui atténue la teneur en UV et en bleu du rayonnement lumineux aboutissant sur l'élément de conversion est disposé entre le filtre (22) à UV et la photodiode semi-conductrice (24).

4. Photodétecteur selon l'une des revendications précédentes, dans lequel l'élément de conversion qui présente la forme d'une couche de silicone (25) dans laquelle le matériau de conversion est incorporé est disposé sur la surface située du côté de la sortie de lumière du filtre (22) laissant passer les UV, sur la surface située du côté de l'entrée de la lumière du filtre de bord (26) éventuellement présent ou sur un autre substrat de support.

5. Photodétecteur selon l'une des revendications précédentes, dans lequel la photodiode semi-conductrice (24) est une photodiode au silicium.

6. Photodétecteur selon l'une des revendications précédentes, dans lequel le filtre (22) à UV et le filtre de bord (26) éventuellement présent sont montés directement sur la surface de la photodiode semi-conductrice (24), en particulier par collage.

7. Photodétecteur selon l'une des revendications précédentes, dans lequel une lentille (1), en particulier en matériau à base de quartz, est disposée en amont du filtre (22) à UV dans la direction du rayonnement.

8. Photodétecteur selon l'une des revendications précédentes, dans lequel le matériau scintillant convient pour être utilisé dans un tube luminescent.
